(19) Europäisches Patentamt
European Patent Office
Office européen des brevets

(11) EP 1 325 053 B1

(12) # EUROPEAN PATENT SPECIFICATION

(45) Date of publication and mention of the grant of the patent:
**21.12.2005 Bulletin 2005/51**

(21) Application number: **01901435.6**

(22) Date of filing: **19.01.2001**

(51) Int Cl.$^7$: **C08G 59/32**, H01L 21/58, H01L 23/495

(86) International application number:
**PCT/JP2001/000314**

(87) International publication number:
**WO 2002/031018 (18.04.2002 Gazette 2002/16)**

(54) **DIE-ATTACHING PASTE AND SEMICONDUCTOR DEVICE**

HAFTUNGSPASTE UND HALBLEITERVORRICHTUNG

PATE DE FIXATION DE PUCES ET DISPOSITIF A SEMICONDUCTEUR

(84) Designated Contracting States:
**DE FR GB IT**

(30) Priority: **11.10.2000 JP 2000310083**

(43) Date of publication of application:
**09.07.2003 Bulletin 2003/28**

(73) Proprietor: **SUMITOMO BAKELITE CO., LTD.**
**Tokyo 140-0002 (JP)**

(72) Inventors:
- **TAKEDA, Toshiro**
  **Utsunomiya-shi, Tochigi 321-0945 (JP)**
- **ONAMI, Kazuto**
  **Utsunomiya-shi, Tochigi 321-0983 (JP)**
- **KAGIMOTO, Tomohiro**
  **Utsunomiya-shi, Tochigi 321-0983 (JP)**

(74) Representative: **Vossius, Volker et al**
**Patent- und Rechtsanwaltskanzlei**
**Geibelstraße 6**
**81679 München (DE)**

(56) References cited:
**EP-A- 0 960 895**

- **DATABASE WPI Section Ch, Week 200025 Derwent Publications Ltd., London, GB; Class A21, AN 2000-286756 XP002170264 & JP 2000 080149 A (SUMITOMO BAKELITE CO LTD), 21 March 2000 (2000-03-21)**
- **DATABASE WPI Section Ch, Week 200025 Derwent Publications Ltd., London, GB; Class A21, AN 2000-286757 XP002170265 & JP 2000 080150 A (SUMITOMO BAKELITE CO LTD), 21 March 2000 (2000-03-21)**
- **PATENT ABSTRACTS OF JAPAN vol. 1998, no. 14, 31 December 1998 (1998-12-31) & JP 10 237157 A (SUMITOMO BAKELITE CO LTD), 8 September 1998 (1998-09-08)**

EP 1 325 053 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

Printed by Jouve, 75001 PARIS (FR)

## Description

TECHNICAL FIELD

The present invention relates to a resin paste used for attaching semiconductor chips such as IC, LSI or the like to a metal frame or the like.

BACKGROUND ART

Owing to the striking growth of electronics industry in recent years, there have been developed transistors, ICs, LSIs and ULSIs in this order; the degree of circuit integration in these chips has seen a sharp increase; the mass production of the chips has become possible; as a result, semiconductor products using the chips have come to be used widely. In this connection, how to increase workability and reduce cost in mass production of the semiconductor products has become an important issue. Conventionally, semiconductor products were generally produced by bonding a chip to a conductor (e.g. a metal frame) by Au-Si eutectic alloying and then sealing the resulting material by hermetic seal. Resin seal was developed, in place of the hermetic seal, for the reasons of workability in mass production and cost, and it is now under general use. In connection therewith, bonding by solder or resin paste (i.e. die-attaching paste) has come to be employed in the mounting, as an improved means for the Au-Si eutectic alloying.

However, the bonding by solder is said to have problems in low reliability, easy staining of chip electrodes, etc. and its use is restricted to chips of power transistor and power IC, requiring high thermal conductivity. In contrast, the bond by die-attaching paste is superior to the bond by solder, in workability, reliability, etc. and the demand for die-attaching paste is increasing rapidly.

In connection with the movement of integration degree of ICs or the like to higher density, chips have become increasingly larger in recent years. On the other hand, copper frame has come to be used for cost reduction, in place of the 42 alloy frame of high cost which was a conventional lead frame. When a chip of ICs or the like having a size of about 4 to 5 mm × 4 to 5 mm or larger is heat-bonded to a copper frame by Au-Si eutectic alloying, however, the chip cause cracking or warpage and invite deteriorated IC properties owing to the difference in thermal expansion coefficient between the chip and the copper frame, and this is posing a problem.

This is because silicon or the like which is a material for chip, has a thermal expansion coefficient of $3 \times 10^{-6}$/°C and the thermal expansion coefficient of the 42 alloy frame is $8 \times 10^{-6}$/°C but that of the copper frame is as large as $20 \times 10^{-6}$/°C . In order to alleviate this problem, it is considered to use bonding by die-attaching paste in place of bonding by Au-si eutectic alloying. When a conventional epoxy (thermosetting resin)-based paste is used as the die-attaching paste, however, it is cured three-dimensionally and therefore its cured product has a high elastic modulus; as a result, the strain appearing between chip and copper frame cannot be absorbed.

When there is used an epoxy resin capable of giving a cured product of low crosslinking density, for example, an epoxy resin containing a large amount of an epoxy monomer, a cured product of low elastic modulus can be obtained but it has a low adhesion strength. Further, an ordinary epoxy resin has a high viscosity and, when mixed with an inorganic filler, gives too high a viscosity, resulting in stringiness at the time of dispensing and consequent low workability. Addition of a large amount of a solvent thereto for improved workability results in generation of voids. In order to solve such an inconvenience, there are inventions (JP-A-2000-80149, JP-A-2000-80150 and JP-A-2000-80151) regarding resin pastes comprising a trifunctional glycidylamine type epoxy resin and a reactive diluent. With these pastes, however, the semiconductor package obtained has a low moisture resistance, when the glycidylamine type epoxy resin in the paste has a high chlorine content.

JP-A-10-237157 describes a liquid resin composition comprising a filler, an epoxy resin, and a curing agent as essential components, and a semiconductor apparatus made by using the same.

EP-A-0 960 895 describes an epoxy resin containing a low content of hydrolyzable chlorine, which is useful for adhesives, paints and electric/electronic materials.

DISCLOSURE OF THE INVENTION

The object of the present invention is to provide a die-attaching paste which has a sufficient hot adhesion strength and gives a cured product of low elastic modulus, and thereby, causes no chip cracking or warpage and resultantly no property deterioration of IC or the like even when used for bonding of a large chip (e.g. IC) to copper frame or the like, and which is rapidly-curable, and generates no void.

The present invention lies in a die-attaching paste comprising, as essential components:

(A) a liquid epoxy resin comprising (a1) an epoxy resin represented by the following general formula (1), containing chlorine in an amount of 500 ppm or less and having a viscosity of 5,000 mPa·s or less at 25°C:

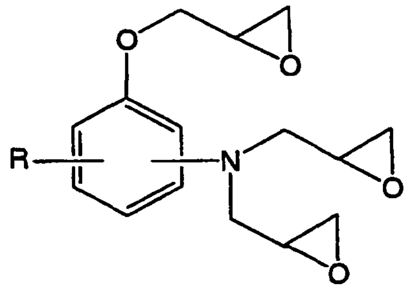

(1)

wherein R is an alkyl group having 1 to 3 carbon atoms or -H, and (a2) an epoxy group-containing reactive diluent containing chlorine in an amount of 300 ppm or less and having a viscosity of 1,000 mPa·s or less, the weight ratio of (a1):(a2) being 40:60 to 90:10,

(B) a phenol compound having at least two hydroxyl groups in the molecule,

(C) a latent curing agent,

(D) an imidazole compound, and

(E) an inorganic filler,

wherein the amounts of the components (B), (C) and (D) are 1 to 10 parts by weight, 0.5 to 5 parts by weight and 0.5 to 10 parts by weight, respectively, per 100 parts by weight of the component (A), and the amount of the component (E) is 25 to 900 parts by weight per 100 parts by weight of the total of the components (A), (B), (C) and (D).

The present invention lies also in a semiconductor device produced by using the above die-attaching paste.

DETAILED DESCRIPTION OF THE INVENTION

The liquid epoxy resin (A) used in the present invention comprises an epoxy resin (a1) represented by the general formula (1) and an epoxy group-containing reactive diluent (a2), and the weight ratio of (a1):(a2) is 40:60 to 90:10. The epoxy resin (a1) represented by the general formula (1) has a chlorine content of 500 ppm or less. A chlorine content of more than 500 ppm is not preferred because the resin paste produced using such an epoxy resin shows a low moisture resistance when used in a semiconductor package. The epoxy resin (a1) represented by the general formula (1) can have various molecular weights; however, an epoxy resin which has a small molecular weight and is liquid at room temperature, is preferred. The epoxy resin (a1) needs to have a viscosity of 5,000 mpa·s or less at 25°C from the standpoints of the workability in compounding of the present die-attaching paste and the workability of the paste compounded.

The epoxy group-containing reactive diluent (a2) to be mixed with the epoxy resin (a1) represented by the general formula (1) is required to have a chlorine content of 300 ppm or less and a viscosity of 1,000 mpa·s or less at 25°C. A chlorine content of more than 300 ppm is not referred because the resin paste produced using such a reactive diluent shows a low moisture resistance when used in a semiconductor package. A viscosity of more than 1,000 mPa·s is not preferred from the standpoint of the workability of the paste compounded. Examples of the reactive diluent (a2) are n-butyl glycidyl ether, glycidyl ester of versatic acid, styrene oxide, ethylhexyl glycidyl ether, phenyl glycidyl ether, cresyl glycidyl ether and butylphenyl glycidyl ether. These compounds can be used singly or in combination of two or more kinds.

The weight ratio of the epoxy resin (a1) represented by the general formula (1) and the epoxy group-containing reactive diluent (a2) is 60:40 to 90:10. When the proportion of the reactive diluent (a2) is more than 40% by weight, the resin paste obtained gives a low adhesion strength; when the proportion is less than 10% by weight, the resin paste obtained has a high viscosity and low workability; therefore, such proportions are not preferred.

In the present invention, other epoxy resins may be used together with the liquid epoxy resin (A) preferably in an amount not exceeding 30% by weight of the total epoxy resins. The other epoxy resin which may be mixed with the liquid epoxy resin (A) includes, for example, aliphatic epoxy resins such as polyglycidyl ether (obtained by a reaction between (a) bisphenol A, bisphenol F, phenolic novolac, cresol novolac or the like and (b) epichlorohydrin), butanediol diglycidyl ether, neopentylglycol diglycidyl ether and the like; heterocyclic epoxy resins such as diglycidyl hydantoin and the like; and alicyclic epoxy resins such as vinylcyclohexene dioxide, dicyclopentadiene dioxide, alicyclic diepoxy adipate and the like. Of these compounds, one kind or a combination of two or more kinds can be used.

The phenol compound (B) used in the present invention functions as a curing agent for epoxy resins. The phenol compound (B) used in the present invention has, in the molecule, two or more active hydroxyl groups capable of reacting with epoxy group to give rise to crosslinking. Examples of such a phenol compound are bisphenol A; bisphenol F; bisphenol S; tetramethylbisphenol A; tetramethylbisphenol F; tetramethylbisphenol S; dihydroxydiphenyl ether; dihydroxybenzophenone; o-hydroxyphenol; m-hydroxyphenol; p-hydroxyphenol; biphenol; tetramethylbiphenol; ethylidenebisphenol; methylethylidenebis(methylphenol); cyclohexylidenebisphenol; phenolic novolac resins obtained by reacting a monohydric phenol (e.g. phenol, cresol or xylenol) with formaldehyde in a dilute aqueous solution under strong acidity; precondensates obtained in a reaction between monohydric phenol and polyfunctional aldehyde (e.g. acrolein or glyoxal) under acidity; and precondensates obtained in a reaction between polyhydric phenol (e.g. resorcin, catechol or hydroquinone) and formaldehyde under acidity. These compounds may be used singly or in admixture.

The phenol compound (B) is used in an amount of 1 to 10 parts by weight per 100 parts by weight of the liquid epoxy resin (A). When the amount of the phenol compound (B) is less than 1 part by weight, neither sufficient adhesivity nor low stress is obtained; when the amount is more than 10 parts by weight, neither sufficient heat resistance nor sufficient adhesivity is obtained; therefore, such amounts are not preferred.

The latent curing agent (C) used in the present invention functions as a curing agent for epoxy resins. It functions as such at high temperatures but does not function so at room temperature. Examples of the latent curing agent (C) are carboxylic acid dihydrazides such as adipic acid dihydrazide, dodecanoic acid dihydrazide, isophthalic acid dihydrazide, p-oxybenzoic acid dihydrazide and the like; and dicyandiamide. When the latent curing agent (C) is used, as compared with when curing is made using only the phenol compound (B), a remarkably higher hot adhesion strength is obtained. Further, since the latent curing agent (C) has a smaller equivalent than the phenol compound (B), the combined use of the agent (C) with the compound (B) can give a resin paste of not so high viscosity. Furthermore, since the agent (C) has latent curability, a resin paste of excellent storage stability can be obtained. The latent curing agent (C) is used in an amount of 0.5 to 5 parts by weight per 100 parts by weight of the liquid epoxy resin (A). When the amount of the latent curing agent (C) is less than 0.5 part by weight, a low hot adhesion strength is obtained; when the amount is more than 5 parts by weight, a sufficient low stress is not obtained; therefore, such amounts are not preferred.

The imidazole compound (D) used in the present invention is an essential component for allowing the resin paste of the present invention to have rapid curability. Examples of the imidazole compound (D) are ordinary imidazoles such as 2-methylimidazole, 2-ethylimidazole, 2-phenylimidazole, 2-phenyl-4-methylimidazole, 2-phenyl-4-methyl-5-hydroxymethylimidazole, 2-phenyl-4,5-dihydroxymethylimidazole, 2-$C_{11}H_{23}$-imidazole and the like; and compounds obtained by adding thereto triazine or isocyanuric acid for higher storage stability, e.g. 2,4-diamino-6-{2-methylimidazole-(1)}-ethyl-s-triazine or its isocyanuric acid adduct. These compounds can be used singly or in admixture of two or more kinds. The imidazole compound (D) is used in an amount of 0.5 to 10 parts by weight per 100 parts by weight of the liquid epoxy resin (A). When the amount of the imidazole compound (D) is less than 0.5 part by weight, the rapid curability of the resulting resin paste is insufficient; when the amount is more than 10 parts by weight, the resulting resin paste shows no more improvement in rapid curability and may show reduced storage stability; therefore, such amounts are not preferred.

The inorganic filler (E) used in the present invention includes a silver powder, a silica filler, etc. The silver powder is used for higher electrical conductivity, and contains ionic impurities (e.g. halogen ions and alkali metal ions) preferably in an amount of 10 ppm or less. The particle shape of the silver powder can be flaky, resinous, spherical or the like. The particle diameters of the silver powder used differ depending upon the required viscosity of the resin paste produced; however, ordinarily, the average particle diameter is preferably 2 to 10 μm and the maximum particle diameter is preferably about 50 μm. It is possible to use a mixture of a relatively coarse silver powder and a fine silver powder. It is also possible to use an appropriate mixture of silver powders of different particle shapes.

The silica filler used in the present invention has an average particle diameter of 1 to 20 μm and the maximum particle diameter of 50 μm or less. When the average particle diameter is less than 1 μm, the resulting resin paste has a high viscosity; when the average particle diameter is more than 20 μm, the resulting resin paste causes resin flow during its coating or curing and resultant bleeding; therefore, such average particle diameters are not preferred. When the maximum particle diameter is more than 50 μm, the outlet of a needle is plugged when the resulting resin paste is coated using a dispenser, making impossible the long continuous use of the needle. It is possible to use a mixture of a relatively coarse silica filler and a fine silica filler. It is also possible to use an appropriate mixture of silica fillers of different particle shapes. An inorganic filler other than the silver power and the silica filler may be used in order to impart a required property.

The amount of the inorganic filler (E) used is 25 to 900 parts by weight per 100 parts by weight of the total of the components (A), (B), (C) and (D). When the amount is less than 25 parts by weight, the cured product of the resulting resin paste has no sufficiently reinforced mechanical properties and has a low adhesion strength under shear. When the amount is more than 900 parts by weight, the resulting resin paste has a high viscosity and low workability.

The resin paste of the present invention may contain, as necessary, additives such as silane coupling agent, titanate coupling agent, pigment, dye, antifoaming agent, surfactant, solvent and the like as long as the properties of the resin paste required for intended application are not impaired.

The resin paste of the present invention can be produced, for example, by premixing individual components,

kneading the premix using a three-roll mill or the like to form a paste, and degassing the paste under vacuum. The semiconductor device of the present invention can be produced by using the die-attaching paste of the present invention and further by using the conventional ordinary method.

BEST MODE FOR CARRYING OUT THE INVENTION

Next, the present invention is specifically described by way of Examples. In the Examples, the proportions of components are shown by parts by weight.

Examples 1 to 9 and Comparative Examples 1 to 10

The components shown in Tables 1 and 2 were compounded and kneaded using a three-roll mill to obtain various resin pastes. Each resin paste was degassed in a vacuum chamber at 2 mmHg for 30 minutes and then measured for properties according to the following methods.

Components used

- Epoxy resin of general formula (1) (epoxy resin a1-1):

  viscosity = 2,000 mPa·s, total chlorine content = 400 ppm, epoxy equivalent = 220

- Epoxy resin of general formula (1) (epoxy resin a1-2):

  viscosity = 4,000 mPa·s, total chlorine content = 350 ppm, epoxy equivalent = 235

- Epoxy resin of general formula (1) (ELM-100 produced by Sumitomo Chemical Co., Ltd., R = $CH_3$):

  viscosity = 4,000 mPa·s, total chlorine content = 3,000 ppm, epoxy equivalent = 250

- Epoxy resin of general formula (1) (E-630 produced by Shell Japan Ltd., R = -H):

  viscosity = 8,000 mpa·s, total chlorine content = 800 ppm, epoxy equivalent = 280

- Bisphenol A type epoxy resin (BPA):

  viscosity = 9,000 mpa·s, epoxy equivalent = 185

- Bisphenol F type epoxy resin (BPF):

  viscosity = 5,000 mPa·s, epoxy equivalent = 170

- Reactive diluent (a2): t-butylphenyl glycidyl ether

  viscosity = 400 mPa·s, total chlorine content = 110 ppm

- Phenol compound (B): bisphenol F
- Latent curing agent (C): dicyandiamide (DDA)
- Imidazole compound (D): 2-phenyl-4-methyl-5-hydroxymethylimidazole (2P4MHZ)
- Inorganic filler (E):

  Silver powder: a flaky silver powder having particle diameters of 0.1 to 50 µm and an average particle diameter of 3 µm

Silica filler: a silica filler having an average particle diameter of 5 µm and the maximum particle diameter of 20 µm

Methods used for evaluation of properties

- Viscosity
  The viscosity of each resin paste was measured using an E type viscometer (3° cone) at 25°C at 2.5 rpm.
- Elastic modulus
  A resin paste was coated on a Teflon sheet by 10 mm width, about 150 mm length and 100 µm thickness. The coated sheet was placed in an oven of 170°C for 30 minutes to give rise to curing of the paste. Then, the resulting film peeled from the Teflon sheet was subjected to a tensile test at a test length of 100 mm and a pulling rate of 1 mm/min to obtain a stress-strain curve. Elastic modulus was calculated from the initial gradient of the curve.
- Adhesion strength
  A 2×2 mm silicon chip was mounted on a copper frame using a resin paste. The resulting material was placed in an oven of 170°C for 30 minutes to give rise to curing of the paste. Then, die shear strength was measured using an adhesion strength tester at 25°C and 250°C.
- Warpage amount
  A 6×15×0.3 mm silicon chip was mounted on a copper frame of 200 µm in thickness using a resin paste. The resulting material was allowed to stand at 170°C for 30 minutes to give rise to curing of the paste. Then, the warpage of the chip was measured using a surface roughness tester (test length: 13 mm).
- Moisture resistance
  A simulated chip obtained by forming aluminum wirings on a silicon chip was mounted on a copper frame of a 16-pin DIP (dual inline package) using a resin paste. The resulting material was placed in an oven of 170°C for 30 minutes to give rise to curing of the paste. Then, gold wire bonding was conducted. Thereafter, transfer molding was conducted using an epoxy molding compound, EME-6300H produced by Sumitomo Bakelite Company Limited, under the conditions of 170°C and 2 minutes, followed by post-curing under the conditions of 175°C and 4 hours. The resulting package was treated in a pressure cooker under the conditions of 125°C, 2.5 atm. and 500 hours, to examine its circuit defective (%).
- Pot life
  A resin paste was allowed to stand in a thermostat of 25°C and measured for the number of days in which the viscosity of the paste became at least 1.2 times the initial viscosity.
- Total chlorine content

About 1 g of an epoxy resin was accurately weighed in a 200-ml flask with flat bottom. Then, zeolite and 25 ml of n-butylcarbitol were added in this order. The resulting mixture was heated to dissolve the epoxy resin. After natural cooling, 25 ml of a 1 N aqueous potassium hydroxide solution was added. The resulting mixture was refluxed for 10 minutes with heating. The mixture was allowed to cool for about 1 hour. The flask contents were transferred into a beaker, and the flask inside was washed with about 50 ml of glacial acetic acid and the washings were transferred into the beaker. Then, potentiometric titration was conducted using a 0.01 N aqueous silver nitrate solution. A blank test was also conducted in the same manner. The total chlorine content in the epoxy resin was determined from the following equation.

$$\text{Total chlorine (wt.\%)} = [\{0.01 \times f \times (V-V') \times AW\}/(W \times 1000)] \times 100$$

f: strength of 0.01 N aqueous silver nitrate solution
V: volume (ml) of 0.01 N aqueous silver nitrate solution used in titration for the epoxy resin
V': volume (ml) of 0.01 N aqueous silver nitrate solution used in titration for blank test
W: weight of the epoxy resin
AW: 35.46

The results of evaluation of properties are shown in Table 1 and Table 2.

Table 1

| | Examples | | | | | | | | |
|---|---|---|---|---|---|---|---|---|---|
| | 1 | 2 | 3 | 4 | 5 | 6 | 7 | 8 | 9 |
| Compounding (weight parts) | | | | | | | | | |
| Epoxy resin a1-1 | 18.2 | 18.2 | 25 | 21 | 30 | 30 | 41 | 35 | |
| Epoxy resin a1-2 | | | | | | | | | 18.2 |
| BPF | | 4.8 | | 4 | | 8 | | 5 | |
| t-Butylphenyl glycidyl ether | 9.8 | 5 | 4 | 4 | 16 | 8 | 5 | 6 | 8.8 |
| Bisphenol F | 1 | 1 | 1 | 1 | 2 | 2 | 2 | 2 | 2 |
| DDA | 0.3 | 0.4 | 0.3 | 0.4 | 0.5 | 0.5 | 0.5 | 0.5 | 0.3 |
| 2P4MHZ | 0.7 | 0.8 | 0.7 | 0.7 | 1.5 | 1.5 | 1.5 | 1.5 | 0.7 |
| Silver powder | 70 | 70 | 70 | 70 | | | | | 70 |
| Silica filler | | | | | 50 | 50 | 50 | 50 | |
| Properties | | | | | | | | | |
| Viscosity (Pa·s) | 15 | 20 | 21 | 23 | 18 | 24 | 26 | 25 | 17 |
| Adhesion strength (gf/chip) | | | | | | | | | |
| 25°C | >4000 | >4000 | >4000 | >4000 | >4000 | >4000 | >4000 | >4000 | >4000 |
| 250°C | 1500 | 1380 | 2070 | 1700 | 1400 | 1360 | 1650 | 1690 | 1400 |
| Warpage amount (μm) | 70 | 75 | 80 | 70 | 80 | 65 | 80 | 76 | 68 |
| Elastic modulus (MPa) | 5096 | 4508 | 5390 | 5292 | 4700 | 4310 | 5100 | 4950 | 5000 |
| Defective (%) in Moisture resistance test | 0 | 0 | 0 | 0 | 0 | 0 | 0 | 0 | 0 |
| Pot life (days) | 6 | 6 | 5 | 7 | 7 | 6 | 5 | 6 | 5 |
| Overall rating | ○ | ○ | ○ | ○ | ○ | ○ | ○ | ○ | ○ |

○ : excellent

Table 2

| | Comparative Examples | | | | | | | | | |
|---|---|---|---|---|---|---|---|---|---|---|
| | 1 | 2 | 3 | 4 | 5 | 6 | 7 | 8 | 9 | 10 |
| Compounding (wt. Parts) | | | | | | | | | | |
| Epoxy resin a1-1 | | | 7 | 26 | 18.2 | 18.2 | | | 16.7 | 21 |
| BPA | 21 | | | | | | | | | |
| BPF | | 21 | | 2 | | | | | | |
| ELM-100 | | | | | | | | 18.2 | | |
| E-630 | | | | | | | 30 | | | |
| t-Butylphenyl glycidyl ether | 7 | 7 | 21 | 2 | 10.8 | 7 | 16 | 10.8 | 7 | 7 |
| Bisphenol F | 1 | 1 | 1 | 1 | | 3.8 | 2 | 1 | 1 | 1 |
| DDA | 0.3 | 0.4 | 0.3 | 0.4 | 0.3 | 0.3 | 0.5 | 0.3 | 0.3 | 0.7 |
| 2P4MHZ | 0.7 | 0.8 | 0.7 | 0.7 | 0.7 | 0.7 | 1.5 | 0.7 | 5 | |
| DBU | | | | | | | | | | 0.3 |
| Silver powder | 70 | 70 | 70 | 70 | 70 | 70 | | 70 | 70 | 70 |
| Silica filler | | | | | | | 50 | | | |
| Properties | | | | | | | | | | |
| Viscosity (Pa·s) | 30 | 25 | 12 | 59 | 16 | 34 | 75 | 24 | 16 | 28 |
| Adhesion strength (gf/chip) | | | | | | | | | | |
| 25°C | >4000 | >4000 | 2050 | 1030 | 3800 | >4000 | 2600 | >4000 | 3500 | 2300 |
| 250°C | 1100 | 1250 | 470 | 600 | 860 | 1200 | 800 | 1750 | 900 | 950 |
| Warpage amount (μm) | * | * | 60 | * | 80 | * | 75 | 75 | 80 | 80 |
| Elastic modulus (MPa) | 7056 | 6960 | 3920 | 8036 | 4900 | 7350 | 5096 | 5488 | 5488 | 5700 |
| Defective (%) in moisture resistance test | 10 | 0 | 30 | 40 | 10 | 0 | 10 | 100 | 60 | 20 |
| Pot life (days) | 7 | 7 | 7 | 5 | 6 | 6 | 4 | 6 | 1 | 5 |
| Overall rating | × | × | × | × | × | × | × | × | × | × |

DBU: 1,8-diazabicyclo(5,4,0)undecene-7 *: Impossible to measure owing to generation of cracking in chip × : inferior

As clear from Tables 1 and 2, Examples 1 to 9 gave resin pastes which were high in hot adhesion strength, low in stress (i.e. small elastic modulus and small warpage amount), long in pot life and superior in moisture resistance. However, in the resin paste of Comparative Example 1, since a bisphenol A type epoxy resin was used, the low stress property was inferior, the warpage amount was large, and chip cracking generated. In the resin paste of Comparative Example 2, since a bisphenol F type epoxy resin was used, the low stress property was inferior, the warpage amount was large, and chip cracking generated. In the resin paste of Comparative Example 3, since the amount of the reactive diluent used was large, the reduction in adhesion strength was striking. In the resin paste of Comparative Example 4, since the amount of the reactive diluent used was small, the viscosity was high, which reduced the workability. In the resin paste of Comparative Example 5, since no phenol compound was used, the adhesion strength was strikingly low. In the resin paste of Comparative Example 6, since the amount of the phenol compound used was large, the hot adhesivity was low. In each of the resin pastes of Comparative Examples 7 and 8, since an epoxy resin of high total chlorine content was used, the moisture resistance was strikingly low. In the resin paste of Comparative Example 9, since the amount of imidazole used was large, the pot life was strikingly short. In the resin paste of Comparative Example 10 which used a tertiary amine in place of an imidazole, the moisture resistance was low.

Thus, the resin paste for a semiconductor according to the present invention has a high hot adhesion strength and is superior in stress relaxation and, therefore, is suitably used in bonding of a large chip (e.g. IC) to copper frame and can prevent the property deterioration of IC or the like, caused by the chip cracking or chip strain appearing in IC assembling.

INDUSTRIAL APPLICABILITY

The resin paste of the present invention is used for bonding of a chip and a metal frame or the like, both constituting a semiconductor device in electronics industry.

**Claims**

1. A die-attaching paste comprising, as essential components:

(A) a liquid epoxy resin comprising (a1) an epoxy resin represented by the following general formula (1), containing chlorine in an amount of 500 ppm or less and having a viscosity of 5,000 mPa·s or less at 25°C:

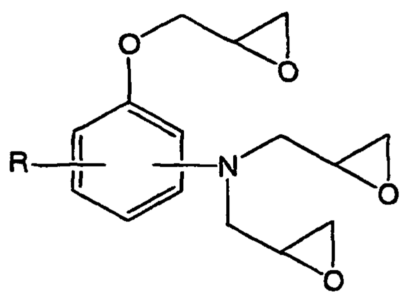

(1)

wherein R is an alkyl group having 1 to 3 carbon atoms or -H, and (a2) an epoxy group-containing reactive diluent containing chlorine in an amount of 300 ppm or less and having a viscosity of 1,000 mPa·s or less at 25°C, the weight ratio of (a1):(a2) being 40:60 to 90:10,
(B) a phenol compound having at least two hydroxyl groups in the molecule,
(C) a latent curing agent,
(D) an imidazole compound, and
(E) an inorganic filler,

wherein the amounts of the components (B), (C) and (D) are 1 to 10 parts by weight, 0.5 to 5 parts by weight and 0.5 to 10 parts by weight, respectively, per 100 parts by weight of the component (A), and the amount of the component (E) is 25 to 900 parts by weight per 100 parts by weight of the total of the components (A), (B), (C) and (D).

2. A semiconductor device produced by using a die-attaching paste set forth in Claim 1.

**Patentansprüche**

1. Chipbondpaste, die als wesentliche Komponenten umfasst:

   (A) ein flüssiges Epoxy-Harz, das (a1) ein Epoxy-Harz der nachstehenden allgemeinen Formel (1), das Chlor in einer Menge von 500 ppm oder weniger enthält und eine Viskosität von 5 000 mPa·s oder weniger bei 25°C aufweist:

   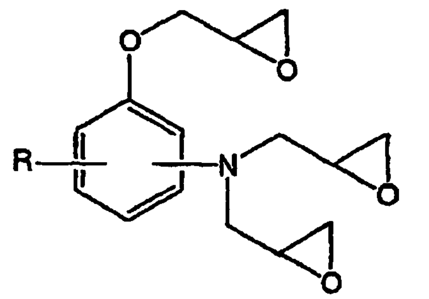

   (1)

   worin R eine Alkylgruppe mit 1 bis 3 Kohlenstoffatomen oder -H ist, und (a2) ein Epoxygruppen-haltiges reaktives Verdünnungsmittel, das Chlor in einer Menge von 300 ppm oder weniger enthält und eine Viskosität von 1 000 mPa·s oder weniger bei 25°C aufweist, umfasst, wobei das Gewichtsverhältnis von (a1):(a2) 40: 60 bis 90: 10 beträgt,
   (B) eine Phenolverbindung mit mindestens zwei Hydroxylgruppen in dem Molekül,
   (C) ein latentes Aushärtungsmittel,
   (D) eine Imidazolverbindung und
   (E) einen anorganischen Füllstoff,

   wobei die Mengen der Komponenten (B), (C) und (D) 1 bis 10 Gewichtsteile, 0,5 bis 5 Gewichtsteile bzw. 0,5 bis 10 Gewichtsteile, pro 100. Gewichtsteile der Komponente (A), betragen und die Menge der Komponente (E) 25 bis 900 Gewichtsteile pro 100 Gewichtsteile der gesamten Menge der Komponenten (A), (B), (C) und (D) beträgt.

2. Halbleitervorrichtung, die unter Verwendung einer Chipbondpaste gemäß Anspruch 1 hergestellt wurde.

**Revendications**

1. Pâte de fixation de puces comprenant, à titre de composants essentiels :

   (A) une résine époxy liquide comprenant (a1) une résine époxy représentée par la formule générale (1) suivante, contenant du chlore en une quantité de 500 ppm ou moins et ayant une viscosité de 5000 mPa.s ou moins à 25°C:

   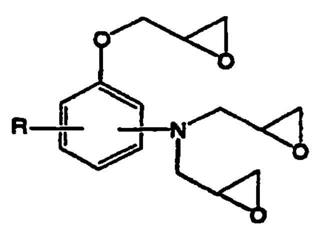

   (1)

   dans laquelle R est un groupe alkyle ayant 1 à 3 atomes de carbone ou un atome de -H, et (a2) un diluant réactif contenant un groupe époxy contenant du chlore en une quantité de 300 ppm ou moins et ayant une viscosité de 1000 mPa.s ou moins à 25°C, le rapport pondéral de (a1):(a2) étant de 40:60 à 90:10,
   (B) un composé phénol ayant au moins deux groupes hydroxyle dans la molécule,

(C) un durcisseur latent,
(D) un composé imidazole, et
(E) une charge inorganique,

dans laquelle les quantités des composants (B), (C) et (D) sont respectivement de 1 à 10 parties en poids, de 0,5 à 5 parties en poids et de 0,5 à 10 parties en poids, pour 100 parties en poids du composant (A), et la quantité du composant (E) est de 25 à 900 parties en poids pour 100 parties en poids du total des composants (A), (B), (C) et (D).

**2.** Dispositif à semiconducteur produit en utilisant une pâte de fixation de puces présentée dans la revendication 1.